Europäisches Patentamt

European Patent Office

Office européen des brevets

(11) Veröffentlichungsnummer: **0 315 891 B1**

# EUROPÄISCHE PATENTSCHRIFT

(45) Veröffentlichungstag der Patentschrift: **27.05.92**

(51) Int. Cl.5: **C23F 1/44**, C23F 1/30

(21) Anmeldenummer: **88118274.5**

(22) Anmeldetag: **03.11.88**

(54) **Badlösungen und Verfahren zum Entfernen von Blei/Zinn-, Blei- bzw. Zinnschichten von Kupfer- oder Nickeloberflächen.**

(30) Priorität: **11.11.87 DE 3738307**

(43) Veröffentlichungstag der Anmeldung:
**17.05.89 Patentblatt 89/20**

(45) Bekanntmachung des Hinweises auf die
Patenterteilung:
**27.05.92 Patentblatt 92/22**

(84) Benannte Vertragsstaaten:
**AT BE CH ES FR GB IT LI LU NL SE**

(56) Entgegenhaltungen:
DE-A- 2 824 975
US-A- 4 713 144

GALVANOTECHNIK, Band 73, Nr. 2, Februar
1982, Seite 180, Salgau, DE; "Entfernen von
Zinn-Blei-Legierungsüberzügen von Kupferoberflächen"

CHEMICAL ABSTRACTS, Band 99, Nr. 10, 5.
September 1983, Seite 276, Nr. 75413q, Columbus, Ohio, US; & JP-A-58 058 280 (MEC
K.K.) 06-04-1983

(73) Patentinhaber: **RUWEL-WERKE SPEZIALFA-
BRIK FÜR LEITERPLATTEN GMBH**
**Postfach 13 55**
**W-4170 Geldern 1(DE)**

(72) Erfinder: **Mika, Günter**
**Vernumer Strasse 56**
**W-4170 Geldern(DE)**

(74) Vertreter: **Königseder, geb. Egerer, Claudia**
**Zugspitzstrasse 65**
**W-8104 Grainau(DE)**

EP 0 315 891 B1

Rank Xerox (UK) Business Services

**Beschreibung**

Es besteht, beispielsweise in der Leiterplattenfertigung, ein Bedarf an Lösungen und Verfahren zum kompletten oder teilweisen Entfernen von auf der Oberfläche eines anderen Metalls, beispielsweise Kupfer oder Nickel, in einem früheren Verfahrensschritt abgeschiedenen Blei-, Zinn- bzw. Blei/Zinnschichten.

Nach einem bekannten Verfahren dient eine solche, elektrochemisch abgeschiedene, dem gewünschten Leiterbild entsprechende Schicht als Ätzmaske.

Nach einem anderen bekannten Verfahren wird eine Zinn/Bleischicht im "hot air levelling"-Prozeß aufgebracht. In der Regel wird die Ätzmaskenschicht anschließend und vor dem Aufbringen einer Lötstoppmaske entfernt.

Es wurde bereits vorgeschlagen, zum Entfernen der Ätzmaske Lösungen auf Peroxidbasis zu verwenden, die anorganische Säuren wie Fluorwasserstoffsäure, Fluorborsäure oder Salpetersäure enthalten. Weiterhin wurde die Verwendung von Peroxid-freien Lösungen vorgeschlagen, nämlich solchen, die beispielsweise Thioharnstoff, Hydroxyphenole, Alkalisalze der m-Nitrobenzosulfonsäure bzw. Mischungen von Fluorborsäure, Fluorwasserstoffsäure und Salpetersäure enthalten.

Weiterhin sind in der Vergangenheit bereits Lösungen und Zusätze zu Lösungen beschrieben worden, die ähnlichen Zwecken dienten. Hierzu gehört ein Bad zum Entfernen von Blei/Zinn-Überzügen, das in Galvanotechnik, Bd. 73 Nr. 2 (1982), Seite 180 beschrieben ist. Der Nachteil der dort beschriebenen Ätzlösung besteht darin, daß diese neben Salpetersäure und Kupferfluoborat auch Polyethylenglykolester von Alkylphenolen enthält. Diese Chemikalien bedürfen einer sehr sorgfältigen und kostspieligen Entsorgung zur Vermeidung von Umweltschäden.

Chemical Abstracts, Band 99, Nr. 10 (1983) auf Seite 276 bezieht sich auf JP-A 58 058280. Dort wird eine Ätzlösung beansprucht, die in erster Linie zum Entfernen von Zinn und Zinnlegierungen von Kupferoberflächen geeignet ist, und die neben Salpetersäure Eisen-III-chlorid und 10% Glykolsäure sowie 0.5% Imidazol enthält. Diese Lösung ist ebenfalls schwer zu entsorgen und hat sich in der Technik nicht eingeführt.

Ein wesentlicher Nachteil der Lösungen nach dem Stand der Technik ist, daß sie Kupfer bzw.- Nickel angreifen, also Leiterzugmaterial mit abtragen. Um den grundsätzlich unerwünschten Abtrag möglichst gering zu halten, sind aufwendige Verfahrenskontrollen erforderlich. Weiterhin haben die bekannten Lösungen nur eine geringe Haltbarkeit und sind wirtschaftlich unbefriedigend. Weitere Nachteile sind ein stark exothermer Reaktionsverlauf sowie der Angriff auf das Isolierstoff-Basismaterial. Aufgabe der vorliegenden Erfindung ist die Herstellung von Lösungen und Verfahren zum wirtschaftlichen Entfernen von auf Nickel-oder Kupferoberflächen aufgebrachten Blei/Zinn-, Blei-bzw. Zinnschichten.

Diese Aufgabe wird durch die im kennzeichnenden Teil des Anspruchs 1 angegebenen Merkmale gelöst. Vorteilhafte Weiterbildungen ergeben sich aus den Unteransprüchen.

Nach der Erfindung ist es in überraschender Weise möglich, den Angriff auf Nickel und Kupfer praktisch vollständig durch Zugabe eines Inhibitors zum Ätzmedium zu vermeiden. Die Lösungen nach der Erfindung sind stabil, erfordern keine besondere Verfahrenskontrolle und ermöglichen in zuverlässiger und wirtschaftlicher Weise das vollständige Entfernen der Ätzmaskenschicht.

Nach der Erfindung wird als Ätzmittel für die Blei/Zinn-, Blei- bzw. Zinnschicht Salpetersäure verwendet. Als erfindungsgemäße Inhibitoren eignen sich Blockcopolymere aus Propylen- und Ethylenoxid, Polyethylenglykole mit einem Molekulargewicht größer als 2000 und Polyole. Als besonders geeignet haben sich erwiesen Blockcoplymere der Typenreihe L30 ® bis F127 ® , Polyole P103 ®, L44 ® und L60 ® von BASF Wyandotte Chemicals sowie FC 95 ® von 3M Company, sowie Polyethylenglykol mit einem Molekulargewicht von 8000. Polyethylenglykol mit einem Molekulargewicht bis 2000 zeigt keine Schutzwirkung.

Die bevorzugte Ätzlösung nach der Erfindung enthält 20 bis 40 Gew.% Salpetersäure und 0.02 bis 0.06 g/l Inhibitor sowie deion. Wasser.

Es hat sich überraschend gezeigt, daß die intermetallische Schicht praktisch ohne Angriff auf das Grundmetall vollständig mit einer Ätzlösung entfernt werden kann, die Eisen-III-chlorid und einen der beiden oben genannten Inhibitoren enthält. Hingegen greifen Lösungen mit den gleichen Inhibitoren und NaCl, $CuCl_2$ oder $Fe_2O_3$ an Stelle von Eisen-III-chlorid das Kupfer stark an. Wird an Stelle von Eisen-III-chlorid $SnCl_4$ benutzt, so stoppt die Ätzwirkung an der intermetallischen Schicht. Die bevorzugte Ätzlösung enthält 5 bis 8 g/l Eisen-III-chlorid, 0.02 bis 0.06 g/l Inhibitor und deion. Wasser.

Nach der Erfindung kann in einem Zweistufen-Verfahren vorgegangen werden, wobei in der ersten Stufe Blei/Zinn, Blei bzw. Zinn und in der zweiten Stufe die intermetallische Schicht entfernt wird. Ein typisches Beispiel für eine erfindungsgemäße Lösung zur Verwendung in der ersten Stufe hat die folgende Zusammensetzung:

```
Lösung I :     wässrige Lösung von HNO₃, 30 Gew.%
               F127                        0.03 g/l
```

Der Ätzvorgang bei Verwendung dieser Lösung stoppt an der intermetallischen Schicht.

```
Lösung II :    Eisen-III-chlorid      7.5  g/l
               F127                   0.02 g/l
```

Arbeitstemperatur für Lösung I und Lösung II: 25°C

Nach der bevorzugten Ausführungsform wird die Erfindung in einem Einstufen-Verfahren angewendet, bei dem die wässrige Ätzlösung den Inhibitor und Salpetersäure sowie Eisen-III-chlorid enthält.

BEISPIEL

Zunächst wird ein zweiseitig kupferkaschiertes Epoxy/Glas-Basismaterial mit den Lochungen versehen, deren Wandungen in der fertigen Leiterplatte einen Metallbelag aufweisen, und die Lochwandmetallisierung wird in an sich bekannter Weise hergestellt. Anschließend wird beidseitig eine dem Negativ des gewünschten Leiterzugmusters entsprechende Galvanik-Maskenschicht aufgebracht. Auf den Masken-freien Bereichen der Kupferoberfläche sowie den metallisierten Lochwandungen wird galvanisch eine Blei/Zinnschicht von 8 bis 10 μm als Ätzmaske aufgebracht.

Die nicht von der Ätzmaske bedeckten Bereiche der Kupferkaschierung werden in an sich bekannter Weise durch Ätzen entfernt. Sodann wird die Blei/Zinn-Ätzmaske einschließlich der intermetallischen Schicht mit der Lösung III entfernt:

```
Lösung III :   Salpetersäure        25 Gew.%
               Eisen-III-chlorid    6.5 g/l
               F127                 0.03 g/l
               deion. Wasser
               Badtemperatur        20 bis 25°C
               Ätzzeit              1.5 bis 2 Min.
```

Die hochglänzende Kupferoberfläche bleibt unverändert erhalten. Ein Angriff auf das Kupfer konnte nicht festgestellt werden.

Die erfindungsgemäßen Lösungen können auch im Sprühverfahren angewendet werden. Hierzu wird vorteilhaft an Stelle von F127 als Inhibitor L63 benutzt.

```
Lösung IV :    Salpetersäure        30 Gew.%
               Eisen-III-chlorid     6   g/l
               L63                  0.03 g/l
               Badtemperatur        25°C
               Dichte               1.136
               pH                   <1
```

Es ist zweckmäßig, zunächst Teillösungen A und B herzustellen. Teillösung A besteht aus

```
200  g/l  Eisen-III-chlorid
0.25 g/l  L63
deion. Wasser
```

Teillösung B besteht aus

```
120  l Wasser
94   kg (52-53%) Salpetersäure
```

Sodann werden zur Lösung B 3.5 l der Lösung A gegeben.

Die Ätzgeschwindigkeit für eine Blei/Zinnschicht beträgt 6 bis 8 $\mu$m/Min., für eine Zinnschicht 4 bis 5 $\mu$m/Min. und für eine Bleischicht 1.5 bis 2 $\mu$m/Min.

Der Ätzbehälter besteht zweckmäßig aus PVC, Polypropylen, Polyethylen, Teflon oder V4A Stahl. Die Temperatur von 25°C max. wird mit Hilfe einer Kühlschlange aus Titan oder V4A eingestellt. Im Betrieb ist Absaugen unbedingt erforderlich, nicht jedoch ein Filtern der Lösung.

Die Kapazität der Lösung beträgt bei Sn/Pb (60/40) etwa 120 bis 140 g/l.

Eine weitere geeignete Lösung nach der Erfindung ist beispielsweise die folgende:

```
Lösung V :   Salpetersäure       25 - 30 Gew.%
             Eisen-III-chlorid    5 -  7 g/l
             FC 95*              0.03 - 0.05 g/l
             deion. Wasser
 * Polyethylenglykol, Mol.Gew. 8000
```

**Patentansprüche**

1. Verfahren zum selektiven Entfernen von auf einer Nickel- oder Kupferoberfläche als Unterlage aufgebrachten Blei/Zinn-, Blei- oder Zinnschichten sowie der intermetallischen Zwischenschicht in einem Verfahrensschritt, dadurch gekennzeichnet, daß die mit der Blei/Zinn-, Blei- oder Zinnschicht versehene Oberfläche mit einer wässrigen Ätzlösung behandelt wird, die Salpetersäure, Eisen-III-chlorid und einen oder mehrere inhibitor(en) aus der Reihe der Blockcopolymere von Propylenoxid and Ethylenoxid, der Polyethylenglykole mit einem Molekulargewicht größer als 2000 und der Polyole enthält, wobei ohne Angriff der Unterlage die Blei/Zinn-, Blei- oder Zinnschichten und die intermetallische Zwischenschicht vollständig entfernt werden.

2. Verfahren nach Anspruch 1, dadurch gekennzeichent, daß die wäßrige Lösung bei einer Temperatur verwendet wird, die 25° C nicht übersteigt.

3. Wäßrige Ätzlösung zur Durchführung des Verfahrens nach Anspruch 1 oder 2 zum selektiven Entfernen von auf einer Nickel-oder Kupferoberfläche als Unterlage aufgebrachten Blei/Zinn-, Blei-oder Zinnschichten sowie der intermetallischen Zwischenschicht in einem Verfahrensschritt, dadurch gekennzeichnet, daß die Lösung Salpetersäure, Eisen-III-chlorid und einen oder mehrere Inhibitor(en) aus der Reihe der Blockcopolymere von Propylen- und Ethylenoxid, der Polyethylenglykole mit einer Molekulargewicht größer als 2000 und der Polyole enthält.

4. Wäßrige Ätzlösung nach Anspruch 3, dadurch gekennzeichnet, daß diese 20 bis 35 Gew.-% Salpetersäure, 5 bis 8 g/l Eisen-III-chlorid, 0.03 bis 0.06 g/l Inhibitor und deionisiertes Wasser enthält.

5. Verfahren zum selektiven Entfernen der nach dem Abätzen einer Blei/Zinn-, Blei- oder Zinnschicht von einer Nickel- oder Kupferoberfläche auf dieser verbleibenden intermetallischen Zwischenschicht, dadurch gekennzeichnet, daß die Zwischenschicht mit einer wäßrigen Lösung behandelt wird, die Eisen-III-chlorid und einen

4

oder mehrere Inhibitor(en) aus der Reihe der Blockcopolymere von Propylen- und Ethylenoxid, der Polyethylenglykole mit einem Molekulargewicht grösser als 2000 und der Polyole enthält.

6. Wäßrige Lösung zur Durchführung des Verfahrens nach Anspruch 5, dadurch gekennzeichnet, daß diese 5 bis 8 g/l Eisen-III-chlorid, 0.03 bis 0.06 g/l Inhibitor und deionisiertes Wasser enthält.

**Claims**

1. A process for selectively removing lead/tin, lead or tin layers, respectively, from a nickel or copper surface applied on a base, as well as of the intermetallic intermediate layer in one process step, characterized in that the surface provided with the lead/tin, lead or tin layer is treated with an aqueous etching solution comprising nitric acid, ferric chloride and one or more inhibitor(s) selected from the group of block-copolymers of propylene oxide and ethylene oxide, of polyethylene glycols with a molecular weight above 2000, and of polyols, thereby completely removing the lead/tin, lead or tin layers and the intermetallic intermediate layer without attacking the base.

2. The process of claim 1, characterized in that the aqueous solution is used at a temperature not exceeding 25°C.

3. An aqueous etching solution for performing the process of claims 1 or 2 for selectively removing lead/tin, lead or tin layers, respectively, from a nickel or copper surface applied on a base, as well as of the intermetallic intermediate layer, in one process step, characterized in that the solution comprises nitric acid, ferric chloride and one or more inhibitor(s) selected from the group of block-copolymers of propylene and ethylene oxide, of polyethylene glycols with a molecular weight above 2000, and of polyols.

4. The aqueous etching solution of claim 3, characterized in that it comprises 20 to 35 % by weight nitric acid, 5 to 8 g/l ferric chloride, 0.03 to 0.06 g/l inhibitor and deionized water.

5. A process for selectively removing the intermetallic intermediate layer remaining on a nickel or copper surface after etching a lead/tin, lead or tin layer, respectively, from said surface, characterized in that the intermetallic intermediate layer is treated with an aqueous solution comprising ferric chloride and one or more inhibitor(s) selected from the group of block-copolymers of propylene and ethylene oxide, of polyethylene glycols with a molecular weight above 2000, and of polyols.

6. An aqueous solution for performing the process of claim 5, characterized in that said solution comprises 5 to 8 g/l ferric chloride, 0.03 to 0.06 g/l inhibitor and deionized water.

**Revendications**

1. Procédé pour éliminer de façon sélective des couches de plomb/étain, de plomb ou d'étain, déposées sur une couche de nickel ou de cuivre en tant que base de support, ainsi que la couche intermédiaire intermétallique en une étape opératoire, caractérisé en ce qu'on traite la surface pourvue de la couche de plomb/étain, de plomb ou d'étain, avec une solution corrosive aqueuse, qui contient de l'acide nitrique, du chlorure ferrique et un ou plusieurs inhibiteurs de la série des copolymères en masse d'oxyde de propylène et d'oxyde d'éthylène, des polyéthylèneglycols possédant un poids moléculaire supérieur à 2000 et des polyols, les couches de plomb/étain, de plomb ou d'étain et la couche intercalaire intermétallique étant complètement éliminées sans attaque de la base de support.

2. Procédé selon la revendication 1, caractérisé en ce qu'on utilise la solution aqueuse à une température ne dépassant pas 25°C.

3. Solution corrosive aqueuse pour la mise en oeuvre du procédé selon la revendication 1 ou 2 pour éliminer de façon sélective des couches de plomb/étain, de plomb ou d'étain déposé sur une surface de nickel ou de cuivre en tant que base de support, ainsi que la couche intercalaire intermétallique en une étape opératoire, caractérisée en ce que la solution contient de l'acide nitrique, du chlorure ferrique et un ou plusieurs inhibiteurs de la série des copolymères en masse de l'oxyde de propylène et de l'oxyde d'éthylène, des polyéthylèneglycols possédant un poids moléculaire supérieur à 2000 et des polyols.

4. Solution corrosive aqueuse selon la revendication 3, caractérisée en ce qu'elle contient 20 à 35 % en poids d'acide nitrique, 5 à 8 g/l de chlorure ferrique, 0,03 à 0,06 g/l d'inhibiteur et de l'eau désionisée.

5. Procédé pour éliminer de façon sélective la couche intercalaire intermétallique qui, après élimination par corrosion d'une couche de plomb/étain, de plomb ou d'étain, d'une surface de nickel ou de cuivre, subsiste sur cette surface, caractérisé en ce qu'on traite la couche intercalaire avec une solution aqueuse qui contient du chlorure ferrique et un ou plusieurs inhibiteurs de la série des copolymères en masse de l'oxyde de propylène et de l'oxyde d'éthylène, des polyéthylèneglycols possédant un poids moléculaire supérieur à 2000 et des polyols.

6. Solution aqueuse pour la mise en oeuvre du procédé selon la revendication 5, caractérisée en ce que cette solution contient 5 à 8 g/l de chlorure ferrique, 0,03 à 0,06 g/l d'inhibiteur et de l'eau désionisée.